# EUROPEAN PATENT SPECIFICATION

(11) **EP 1 797 151 B1**
(45) Date of publication and mention of the grant of the patent: **14.12.2011**
(21) Application number: 05760474.6
(22) Date of filing: 10.06.2005
(51) Int. Cl.: C09G 1/02, H01L 21/02, H01L 21/3105

(54) **CMP COMPOSITION FOR IMPROVED OXIDE REMOVAL RATE**
CMP-ZUSAMMENSETZUNG FÜR VERBESSERTE OXIDENTFERNUNGSGESCHWINDIGKEIT
COMPOSITION DE POLISSAGE CHIMICO-MECANIQUE A TAUX D'ELIMINATION D'OXYDE AMELIORE

(30) Priority: 18.06.2004 US 871774
(43) Date of publication of application: 20.06.2007
(73) Proprietor: CABOT MICROELECTRONICS, Aurora, IL 60504 (US)
(72) Inventor: CARTER, Phillip, Legal Department, Cabot Micr.Corp, Aurora, Illinois 60504 (US); VACASSY, Robert, Legal Department, Aurora, Illinois 60504 (US)
(74) Representative: Johnson, Yvonne Catherine
(86) International application number: PCT/US2005/020614
(87) International publication number: WO 2006/009640

(56) References cited:
- WO-A-2004/037937
- US-A1- 2003 073 593
- US-A1- 2004 055 993
- ROHM AND HAAS ELECTRONIC MATERIALS: "MSW2000 Polishing Slurry"[Online] XP002345568 Retrieved from the Internet: URL:http://www.eminess.com/documents/MSW20 00.pdf> [retrieved on 2005-09-19]

## Description

### BACKGROUND OF THE INVENTION

As a method for isolating elements of a semiconductor device, a great deal of attention is being directed towards a shallow trench isolation (STI) process where a silicon nitride layer is formed on a silicon substrate, shallow trenches are formed via etching or photolithography, and a dielectric layer is deposited to fill the trenches. Due to variation in the depth of trenches formed in this manner, it is typically necessary to deposit an excess of dielectric material on top of the substrate to ensure complete filling of all trenches.

The dielectric material (e.g., an oxide) conforms to the underlying topography of the substrate. Thus, the surface of the substrate is characterized by raised areas of the overlying oxide between trenches, which are referred to as pattern oxide. The excess dielectric lying outside of the trenches is then typically removed by a chemical-mechanical planarization process, which additionally provides a planar surface for further processing. As pattern oxide is abraded and planarity of the surface is approached, the oxide layer is then referred to as blanket oxide.

Compositions and methods for planarizing or polishing the surface of a substrate are well known in the art. Polishing compositions (also known as polishing slurries) typically contain an abrasive material in a liquid carrier and are applied to a surface by contacting the surface with a polishing pad saturated with the polishing composition. Typical abrasive materials include silicon dioxide, cerium oxide, aluminum oxide, zirconium oxide, and tin oxide. U.S. Patent 5,527,423, for example, describes a method for chemically-mechanically polishing a metal layer by contacting the surface with a polishing slurry comprising high purity fine metal oxide particles in an aqueous medium. Polishing compositions are typically used in conjunction with polishing pads (e.g., a polishing cloth or disk). Suitable polishing pads are described in U.S. Patents 6,062,968, 6,117,000, and 6,126,532, which disclose the use of sintered polyurethane polishing pads having an open-celled porous network, and U.S. Patent 5,489,233, which discloses the use of solid polishing pads having a surface texture or pattern. Instead of or in addition to being suspended in the polishing composition, the abrasive material may be incorporated into the polishing pad. U.S. Patent 5,958,794 discloses a fixed abrasive polishing pad.

Several chemical-mechanical polishing compositions for substrates containing low dielectric constant materials are known. For example, U.S. Patent 6,043,155 discloses a cerium oxide-based slurry for inorganic and organic insulating films. U.S. Patent 6,046,112 discloses a polishing composition for polishing low dielectric materials comprising zirconia abrasive and either tetramethylammonium hydroxide or tetrabutylammonium hydroxide. U.S. Patent 6,270,395 discloses a polishing composition for low dielectric materials comprising abrasive and an oxidizing agent.

Often the rate of removal of the silicon oxide pattern can be rate-limiting for the dielectric polishing step in STl processes, and therefore high removal rates are desired to increase device throughput. In polishing of pattern oxide, there is an initiation or induction period before the rate of oxide removal becomes useful. A method of chemical-mechanical polishing that reduced the duration of the initiation or induction period would therefore reduce the time needed for planarization of the substrate. However, if the blanket removal rate is too rapid, overpolishing of oxide in exposed trenches results in trench erosion and increased device defectivity.

Thus, there remains a need for improved polishing compositions and methods for planarization of silicon oxide substrates. The invention provides such a polishing composition and method. These and other advantages of the invention, as well as additional inventive features, will be apparent from the description of the invention provided herein.

### BRIEF SUMMARY OF THE INVENTION

The invention provides a chemical-mechanical polishing composition comprising (a) 0.01 wt.% to 1 wt.% of , ceria, (b) 0.05 mM to 30 mM of a halide salt comprising I⁻, and (c) water. The invention further provides a method for chemically-mechanically polishing a substrate comprising (a) contacting a substrate with a polishing pad and the chemical-mechanical polishing composition, (b) moving the polishing pad relative to the substrate with the chemical-mechanical polishing composition therebetween, and (c) abrading at least a portion of the substrate to polish the substrate.

### DETAILED DESCRIPTION OF THE INVENTION

The invention provides a chemical-mechanical polishing composition comprising (a) an abrasive, (b) a halide salt, and (c) water. The polishing composition desirably allows for increased removal rates of pattern oxide and reduced removal rates of blanket oxide in chemical-mechanical planarization of substrates comprising low dielectric layers.

The term "component" as used herein includes individual ingredients (e.g., acids, bases, etc.) as well as any combination of ingredients (e.g., acids, bases, surfactants, etc.).

Disclosed abrasives are selected from the group consisting of alumina, ceria, and zirconia. The abrasive in the chemical mechanical polishing composition of the invention is ceria. The amount of abrasive present in the polishing composition is 0.01 wt.% or more (e.g., 0.02 wt.% or more, 0.05 wt.% or more, or 0.1 wt.% or more) based on the weight of the liquid carrier and any components dissolved or suspended therein. The amount of abrasive present in the polishing composition is 1 wt.% or less (e.g., 0.5 wt.% or less) based on the weight ofthe liquid carrier and any components dissolved or suspended therein.

Disclosed halide salts are any salt having an anion selected from the group consisting of Cl⁻, Br⁻, and I⁻. The halide salt in the chemical mechanical polishing composition of the invention comprises the anion I⁻. The cation of the halide salt can be any suitable cation. Desirably, the halide salt comprises a metal cation. Preferably, the metal cation does not exhibit chemical reactivity with the substrate or any components of the polishing composition under the polishing conditions. More preferably, the cation is selected from the group consisting OfLi⁺, Na⁺, K⁺, Mg²⁺, Ca²⁺, Sr²⁺, Ba²⁺, and Fe²⁺. Most preferably, the halide salt is potassium iodide ("KI"). The halide salts also can be ammonium halides and pyridinium halides. The ammonium halide salt preferably is NH₄I, and the pyridinium halide salt preferably is C₅H₅NHI.

The concentration of halide salt in the polishing composition is 0.05 mM or more (e.g., 0.1 mM or more). The concentration of halide salt in the polishing composition is 30 mM or less (e.g., 10 mM or less, or 5 mM or less). The presence of a halide salt in a concentration greater than 30 mM can result in retardation of blanket oxide removal to unacceptably low rates. The desired concentration of halide salt can be achieved by any suitable means, such as by using 0.01 wt.% to 0.5 wt.% of the halide salt based on the weight of the liquid carrier and any components dissolved or suspended therein in the preparation of the polishing composition.

The chemical-mechanical polishing composition has a pH that is less than 9 (e.g., 8 or less, or 7 or less). Preferably, the polishing composition has a pH of 3 or more (e.g., 4 or more). Even more preferably, the polishing composition has a pH of 4 to 7. The polishing composition optionally comprises pH adjusting agents, for example sodium hydroxide or hydrochloric acid. The polishing composition can optionally comprise pH buffering systems, for example ammonium acetate or disodium citrate. Such pH buffering systems are well known in the art.

The chemical-mechanical polishing composition optionally comprises an organic carboxylic acid. Carboxylic acids useful in the chemical-mechanical polishing composition of the invention include monocarboxylic and dicarboxylic acids and their salts. Preferably, the carboxylic acid is selected from the group consisting of acetic acid, propionic acid, butyric acid, benzoic acid, formic acid, malonic acid, succinic acid, tartaric acid, lactic acid, phthalic acid, salicylic acid, anthranilic acid, citric acid, glycolic acid, fumaric acid, lauric acid, pyruvic acid, stearic acid, chloroacetic acid, dichloroacetic acid, 2-pyridinecarboxylic acid, glycine, alanine, 3-aminopropionic acid, 4-aminobutyric acid, derivatives thereof, salts thereof, and combinations thereof. More preferably, the carboxylic acid is an amino carboxylic acid.

The chemical-mechanical polishing composition can comprise any suitable amount of the carboxylic acid and typically comprises 0.0001 wt.% or more of such acid. Preferably, the polishing composition comprises 0.001 wt.% to 0.5 wt.% carboxylic acid. More preferably, the polishing composition comprises 0.001 wt.% to 0.25 wt% carboxylic acid.

It will be appreciated that the aforementioned carboxylic acids can exist in the form of a salt (e.g., a metal salt, an ammonium salt, or the like), an acid, or as a partial salt thereof. For example, tartrates include tartaric acid, as well as mono- and di-salts thereof. Furthermore, carboxylic acids including basic functional groups can exist in the form of an acid salt of the basic functional group. For example, glycines include glycine, as well as monoacid salts thereof. Furthermore, some compounds can function both as an acid and as a chelating agent (e.g., certain amino acids and the like).

The carboxylic acid serves several functions in the polishing composition. The carboxylic acid serves to buffer the pH of the system and imparts a degree of selectivity for oxide dielectric materials over underlying silicon nitride. The acid additionally enhances the oxide removal rate and improves the colloidal stability ofthe polishing composition.

The chemical-mechanical polishing composition optionally further comprises one or more other additives. Such additives include any suitable surfactant and/or rheological control agent, including viscosity enhancing agents and coagulants (e.g., polymeric rheological control agents, such as, for example, urethane polymers), acrylates comprising one or more acrylic subunits (e.g., vinyl acrylates and styrene acrylates), and polymers, copolymers, and oligomers thereof, and salts thereof. Suitable surfactants include, for example, cationic surfactants, anionic surfactants, anionic polyelectrolytes, nonionic surfactants, amphoteric surfactants, fluorinated surfactants, mixtures thereof, and the like.

The chemical-mechanical polishing composition can be used to polish any substrate, and is especially useful for polishing substrates comprising at least one layer (typically a surface layer) comprised of a low dielectric material. Suitable substrates include wafers used in the semiconductor industry. The wafers typically consist of, for example, a metal, metal oxide, metal nitride, metal composite, metal alloy, a low dielectric material, or combinations thereof. The method of the invention is particularly useful for polishing substrates comprising silicon dioxide.

The chemical-mechanical polishing composition is particularly well-suited for planarizing or polishing a substrate that has undergone shallow trench isolation (STI) processing. STI processing typically involves providing a silicon substrate on which is deposited a layer of silicon nitride. Trenches are etched onto a substrate consisting of a layer of silicon nitride following photolithography, and an excess of silicon dioxide is deposited thereon. The substrate is then subjected to planarization until the silicon nitride is fully exposed, such that the silicon oxide remaining in the trenches is approximately level with the silicon nitride. Desirably, the planarization or polishing is carried out in such typical STI processing with the chemical-mechanical polishing composition of the invention, preferably such that the silicon dioxide is removed and planarization stops at the silicon nitride layer.

The chemical-mechanical polishing composition is especially useful for chemical-mechanical polishing. In this regard, the invention provides a method for chemical-mechanical polishing comprising (a) contacting a substrate with the chemical-mechanical polishing composition and a polishing pad, (b) moving the polishing pad relative to the substrate with the chemical-mechanical polishing composition therebetween, and (c) abrading at least a part of the substrate to polish the substrate. In a typical process of chemical-mechanical polishing, a substrate (such as a semiconductor wafer) is pressed against a polishing pad in the presence of a polishing composition under controlled chemical, pressure, velocity, and temperature conditions. The relative motion of the substrate and pad can be circular, elliptical, or linear. Typically, the relative motion of the substrate and pad is circular.

A substrate can be planarized or polished with the chemical-mechanical polishing composition by any suitable technique. In this regard, it is suitable for the polishing composition to be formulated prior to delivery to the polishing pad or to the surface of the substrate. It is also suitable for the polishing composition to be formulated (e.g., mixed) on the surface of the polishing pad or on the surface of the substrate, through delivery of the components of the polishing composition from two or more distinct sources, whereby the components of the polishing composition meet at the surface of the polishing pad or at the surface of the substrate. In this regard, the flow rate at which the components of the polishing composition are delivered to the polishing pad or to the surface of the substrate (i.e., the delivered amount of the particular components of the polishing composition) can be altered prior to the polishing process and/or during the polishing process, such that the polishing selectivity and/or viscosity of the polishing composition is altered. Moreover, it is suitable for the particular components of the polishing composition being delivered from two or more distinct sources to have different pH values, or alternatively to have substantially similar, or even equal, pH values, prior to delivery to the surface of the polishing pad or to the surface of the substrate. It is also suitable for the particular components being delivered from two or more distinct sources to be filtered either independently or to be filtered jointly (e.g., together) prior to delivery to the surface of the polishing pad or to the surface of the substrate.

A substrate can be planarized or polished with the chemical-mechanical polishing composition with any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

The following Examples further illustrate the invention but, of course, should not be construed as in any way limiting its scope.

In the Examples below, Blanket Removal Rate is the rate of reduction in Å/min of a silicon dioxide layer with an essentially continuous surface. 100% Active Removal Rate is the rate of reduction in Å/min of a silicon dioxide layer that is approximately 100% accessible to the polishing pad and is synonymous with Blanket Removal Rate. 50% Active Removal Rate is the rate of reduction in Å/min of a patterned silicon dioxide layer of which approximately 50% of the surface is accessible to the polishing pad. The polishing experiments generally involved use of a 50.8 cm (20 inch) polishing tool with 27.6 kPa (4 psi) down force pressure of the substrate against the polishing pad, 60 rpm platen speed, 56 rpm carrier speed, 200 mL/min polishing composition flow rate, and use of in-situ conditioning of a concentric grooved CMP pad. In these Examples, the term oxide is synonymous with silicon dioxide.

### EXAMPLE 1

This example illustrates the significance of the introduction of KI on 100% active removal rate and on 50% active removal rate for various abrasives. Polishing compositions containing water and either 0.15 wt% ceria,1 wt.% zirconia (ZrO₂), 3 wt.% fumed alumina, 10 wt.% fumed silica, or 10 wt.% colloidal silica in water were prepared in duplicate, with one of each duplicate composition also containing KI. Each of the polishing compositions had a pH of 5. The colloidal silica was characterized in being supplied as a stable dispersion of silica in water with a particle size range of 10-150 nm. Similar silicon dioxide layers were polished separately with each of the different polishing compositions. Following use of the polishing compositions, the 100% active removal rate and 50% active removal rate of silicon dioxide (SiO₂) by each of the polishing compositions was determined, with the resulting data set forth in Table 1.

**Table 1:**

| Composition | Abrasive | KI | 100% Active Removal Rate (Å/min) | 50% Active Removal Rate (Å/min) |
|---|---|---|---|---|
| 2A (comparative) | ceria | no | 3924 | 6416 |
| 2B (invention) | ceria | yes | 1917 | 6938 |
| 2C (comparative) | ZrO₂ | no | 1412 | 2472 |
| 2D (comparative) | ZrO₂ | yes | 1447 | 2731 |
| 2E (comparative) | fumed alumina | no | 247 | 481 |
| 2F (comparative) | fumed alumina | yes | 31 | 288 |
| 2G (comparative) | fumed silica | no | 116 | 1407 |
| 2H (comparative) | fumed silica | yes | 225 | 1412 |
| 21 (comparative) | colloidal silica | no | 462 | 1165 |
| 2J (comparative) | colloidal silica | yes | 550 | 1311 |

As is apparent from the data set forth in Table 1, the addition of Kl to the polishing composition containing ceria resulted in an approximately 51% decrease in the 100% active removal rate, and an approximately 8% increase in the 50% active removal rate. For the polishing composition containing zirconia, the addition of KI resulted in an approximately 2% increase in the 100% active removal rate, and an approximately 9% increase in the 50% active removal rate. For the polishing composition containing fumed alumina, the addition of K1 resulted in an approximately 87% decrease in the 100% active removal rate, and an approximately 40% decrease in the 50% active removal rate. In contrast, for the polishing composition containing fumed silica, the addition of KI resulted in an approximately 94% increase in the 100% active removal rate, and essentially no change in the 50% active removal rate. Similarly, the polishing composition containing colloidal silica showed an approximately 19% increase in the 100% active removal rate, and a 13% increase in the 50% active removal rate, with the addition of KI.

The effect was greatest for the ceria-containing composition in which both a desirable increase in 50% active removal rate and desirable decrease in 100% active removal rate were observed. For the zirconia-containing compositions, the 100% active removal rate was changed slightly, but the 50% active removal rate was increased. In fumed alumina-containing compositions, the removal rates on both surfaces decreased, but the ratio of 50% active removal rate to 100% active removal rate changed beneficially from 2:1 to 9:1. The silica-containing compositions showed undesirable increases in both 100% active removal rate and 50% active removal rate with the addition of KI. Thus, the results of this example demonstrate the effects on removal rates for two different surface types achievable by the polishing composition of the invention.

### EXAMPLE 2

This example illustrates the significance of the halide anion in the polishing composition of the invention, in affecting the blanket removal rate and 50% active removal rate. Polishing compositions were prepared containing ceria and different salts (specifically, 0.5 mM KNO₃, 0.5 mM KCl, 0.5 mM KI, 0.25 mM K₂C₂O₄, 0.5 mM K₂C₂O₄, 2.0 mM KCI, and 0.5 mM K₂SO₄) in water. Similar silicon dioxide layers were polished separately with each of the different polishing compositions. Hollowing use ofthe polishing compositions, the blanket removal rate and 50% active removal rate were determined, with the resulting data set forth in Table 2.

**Table 2:**

| Composition | Salt | Blanket Removal Rate (Å/min) | 50% Active Removal Rate (Å/min) |
|---|---|---|---|
| 3 A (control) | none | 4468 | 3655 |
| 3B (comparative) | 0.5 mM KNO₃ | 2546 | 2942 |
| 3C (invention) | 0.5 mM KI | 322 | 5472 |
| 3D (comparative) | 0.5 mM KCI | 1153 | 4193 |
| 3E (comparative) | 2.0 mM KCI | 806 | 4717 |
| 3F (comparative) | 0.25 mM K₂C₂O₄ | 459 | 329 |
| 3G (comparative) | 0.5 mM K₂C₂O₄ | 208 | 131 |
| 3H (comparative) | 0.5 mM K₂SO₄ | 3055 | 3052 |

As is apparent from the data set forth in Table 2, the presence of KI or KCl resulted in a decrease in the blanket removal rate and an increase in the 50% active removal rate as compared to the control composition. The presence OfKNO₃ or K₂SO₄ resulted in a decrease in removal rates for both substrate features, and the presence OfK₂C₂O₄ resulted in greatly reduced removal rates for both substrate features. Thus, the results of this example demonstrate the significance of the anions present in the polishing composition and the beneficial effects resulting from the presence of halide ions in the polishing composition of the invention.

## Claims

1. A chemical-mechanical polishing composition comprising:
(a) 0.01 wt.%to 1 wt.% of ceria,
(b) 0.05 mM to 30 mM of a halide salt comprising I⁻, and
(c) water,
wherein the polishing composition has a pH of less than 9.

2. The chemical-mechanical polishing composition of claim 1, wherein the polishing composition has a pH of 3 to 8.

3. The chemical-mechanical polishing composition of claim 1, wherein the halide salt comprises a cation selected from the group consisting of Li⁺, Na⁺, K⁺, Mg⁺, Ca²⁺, Sr²⁺, Ba²⁺, Fe²⁺, NE₄⁺, and C₅H₅NH⁺.

4. The chemical-mechanical polishing composition of claim 3, wherein the halide salt is KI.

5. The chemical-mechanical polishing composition of claim 1, wherein the ceria is present in the amount or 0.01 wt.% to 0.5 wt.%.

6. The chemical-mechanical polishing composition of claim 1, wherein the halide salt is present in a concentration of 0.1 mM to 10 mM.

7. The chemical-mechanical polishing composition of claim 1, further comprising an organic carboxylic acid.

8. The chemical-mechanical polishing composition of claim 7, wherein the organic carboxylic acid is selected from the group consisting of monocarboxylic acids and dicarboxylic acids.

9. The chemical-mechanical polishing composition of claim 8, wherein the organic carboxylic acid is an amino carboxylic acid.

10. A method of chemical-mechanical polishing comprising:
(a) contacting a substrate with a polishing pad and a chemical-mechanical polishing composition as defined in any one a claims 1 to 9
(b) moving the polishing pad relative to the substrate with the chemical-mechanical polishing composition therebetween, and
(c) abrading at least a portion of the substrate to polish the substrate.

11. The method of claim 10, wherein the substrate comprises silicon dioxide.

## Patentansprüche

1. Chemisch-mechanische Polierzusammensetzung, welche Folgendes aufweist:
a) 0,01 Gew.-% bis 1 Gew.-% Ceroxid,
b) 0,05 mM bis 30 mM eines Halogenidsalzes, welches I-aufweist, und
c) Wasser, wobei die Polierzusammensetzung einen pH-Wert von weniger als 9 aufweist.

2. Chemisch-mechanische Polierzusammensetzung nach Anspruch 1, wobei die Polierzusammensetzung einen pH-Wert von 3 bis 8 aufweist.

3. Chemisch-mechanische Polierzusammensetzung nach Anspruch 1, wobei das Halogenidsalz ein Kation aufweist, das aus der Gruppe ausgewählt ist, die aus Li+, Na+, K+, Mg+, Ca2+, Sr2+, Ba2+, Fe2+, NH4+ und C5H5NH+ besteht.

4. Chemisch-mechanische Polierzusammensetzung nach Anspruch 3, wobei das Halogenidsalz KI ist.

5. Chemisch-mechanische Polierzusammensetzung nach Anspruch 1, wobei das Ceroxid in der Menge von 0,01 Gew.-% bis 0,5 Gew.-% vorhanden ist.

6. Chemisch-mechanische Polierzusammensetzung nach Anspruch 1, wobei das Halogenidsalz in einer Konzentration von 0,1 mM bis 10 mM vorhanden ist.

7. Chemisch-mechanische Polierzusammensetzung nach Anspruch 1, welche des Weiteren eine organische Karboxylsäure aufweist.

8. Chemisch-mechanische Polierzusammensetzung nach Anspruch 7, wobei die organische Karboxylsäure aus der Gruppe ausgewählt ist, die aus Monokarboxylsäuren und Dikarboxylsäuren besteht.

9. Chemisch-mechanische Polierzusammensetzung nach Anspruch 8, wobei die organische Karboxylsäure eine Amino-Karboxylsäure ist.

10. Verfahren zum chemisch-mechanischen Polieren, welches Folgendes aufweist:
a) Kontaktieren eines Substrats mit einem Polierkissens und einer chemischmechanischen Polierzusammensetzung nach einem der Ansprüche 1 bis 9,
b) Bewegen des Polierkissens relativ zu dem Substrat, wobei sich die chemisch-mechanische Polierzusammensetzung dazwischen befindet, und
c) Abtragen von wenigstens eines Teils des Substrats, um das Substrat zu polieren.

11. Verfahren nach Anspruch 10, wobei das Substrat Silikondioxid enthält.

## Revendications

1. Composition de polissage chimico-mécanique comprenant :
(a) de 0,01 % en poids à 1 % en poids d'oxyde de cérium,
(b) de 0,05 mM à 30 mM d'un sel d'halogénure comprenant I⁻ et
(c) de l'eau,
laquelle composition de polissage a un pH de moins de 9.

2. Composition de polissage chimico-mécanique selon la revendication 1, dans laquelle la composition de polissage a un pH de 3 à 8.

3. Composition de polissage chimico-mécanique selon la revendication 1, dans laquelle le sel halogénure comprend un cation choisi dans le groupe constitué par Li⁺, Na⁺, K⁺, Mg⁺, Ca²⁺, Sr²⁺, Ba²⁺, Fe²⁺, NH₄⁺ et C₃H₅NH⁺.

4. Composition de polissage chimico-mécanique selon la revendication 3, dans laquelle le sel halogénure est KI.

5. Composition de polissage chimico-mécanique selon la revendication 1, dans laquelle l'oxyde cérium est présent dans la quantité de 0,01 % en poids à 0,5 % en poids.

6. Composition de polissage chimico-mécanique selon la revendication 1, dans laquelle le sel halogénure est présent dans une concentration de 0,1 mM à 10 mM.

7. Composition de polissage chimico-mécanique selon la revendication 1, comprenant en outre un acide organique carboxylique.

8. Composition de polissage chimico-mécanique selon la revendication 7, dans laquelle l'acide organique carboxylique est choisi dans le groupe constitué par les acides monocarboxyliques et les acides dicarboxyliques.

9. Composition de polissage chimico-mécanique selon revendication 8, dans laquelle l'acide organique carboxylique est un acide aminocarboxylique.

10. Procédé de polissage chimico-mécanique comprenant :
(a) la mise en contact d'un substrat avec un tampon de polissage et une composition de polissage chimico-mécanique telle que définie dans l'une quelconque des revendications 1 à 9,
(b) le déplacement du tampon de polissage par rapport au substrat avec la composition de polissage chimico-mécanique entre ceux-ci et
(c) l'abrasion d'au moins une partie du substrat pour polir le substrat.

11. Procédé selon la revendication 10, dans lequel le substrat comprend du dioxyde de silicium.
